Europäisches Patentamt

European Patent Office

Office européen des brevets

(19)

(11) Publication number: **0 211 855**
**B1**

(12) **EUROPEAN PATENT SPECIFICATION**

(45) Date of publication of the patent specification:
28.02.90

(21) Application number: 86900817.7

(22) Date of filing: 27.01.86

(86) International application number:
PCT/GB 86/00048

(87) International publication number:
WO 86/04996 (28.08.86 Gazette 86/19)

(51) Int. Cl.[5]: **G 02 B 1/02, C 30 B 15/00,**
**C 30 B 29/32, G 01 T 1/202,**
**G 02 B 1/08, G 02 B 6/10,**
**G 02 F 1/05, G 02 F 1/11,**
**G 02 F 1/13, G 11 B 7/00**

(54) OPTICAL COMPONENTS.

(30) Priority: 13.02.85 GB 8503644

(43) Date of publication of application:
04.03.87 Bulletin 87/10

(45) Publication of the grant of the patent:
28.02.90 Bulletin 90/09

(84) Designated Contracting States:
DE FR GB IT

(56) References cited:

Ferroelectrics, Third Soviet-Japanese Symposium on Ferroelectricity, Novosibirsk, USSR, 9-14 September 1984, volume 63, no. 1-4, June 1985, London (GB); Y. VENEVTSEV et al.: "New ferroelectric oxids: synthesis, crystal structures, phase transitions and properties", pages 217-226.

J. Electrochemical Society, volume 120, no. 7, July 1973, Princeton, (US); T. ISAACS et al.: "Emission of Eu3+ in some calcium germanates", pages 997-999.

Sov. Phys. Dokl., volume 24, no. 6, June 1979, New York, (US); N. NEVSKII et al.: "The crystal structure of CaGe205- a germanium analog of sphene", pages 415-416.

(73) Proprietor: **The Secretary of State for Defence in Her Britannic Majesty's Government of the United Kingdom of Great Britain and Northern Ireland Whitehall London SW1A 2HB (GB)**

(72) Inventor: BORN, Peter, Jeremy
The Coach House Putley
Nr. Ledbury Hertfordshire HR8 2QP (GB)
Inventor: ROBERTSON, Daniel, Stewart
205 Pickersleigh Road
Malvern Worcestershire WR4 2QS (GB)
Inventor: YOUNG, Iain, Malcolm
Flat 3 Redwing House Hospital Road
Halfkey, Malvern Worcestershire WR14 1UL (GB)

(74) Representative: Beckham, Robert William
Procurement Executive Ministry of Defence Patents 1A(4), Room 2014
Empress State Building Lillie Road London SW6 1TR (GB)

LIBERGRAF, STOCKHOLM 1990

## Description

This invention relates to optical components which perform a function on incident radiation. Such a function may be focussing, switching or guiding of light; or a change in optical transmission to form optical storage etc. The term radiation includes infrared, visible, ultra violet, and wavelengths including and beyond X-rays.

One form of optical storage is described in Westcon Technical Papers, Vol. 15, 24-27 August 1971; 31/4; G. W. Taylor "The Application of Ferroelectric Materials in Optical Memories". In this paper an optical storage medium is formed of single crystal $Bi_4Ti_3O_{12}$ plate coated on one face with a photoconductive layer and sandwiched between two transparent electrodes. Information is written into the crystal by a scanning light beam directed onto the photoconductive layer whilst a positive voltage pulse is applied to the transparent electrodes. This causes a localised change in the c-axis component of polarization. These localised changes in birefringence are observable between two polarisers. Information is erased by flooding the whole photoconductive layer with light whilst applying a suitable negative voltage pulse to the transparent electrodes.

One compound in the calcium dioxide – germanium dioxide phase diagram is calcium mesodigermanate ($CaGe_2O_5$). This has previously been prepared and studied as a component of specialised cements in microcrystalline form. See for example article by Gid. Smt. Vyrasch Monokrist 1982 p. 216-228, Chemabs 98184532.

See also Ferroelectrics, 3rd Soviet-Japanese Symposium of Ferroelectricity, Novosibrirsk, USSR, 9-14 September 1984, Vol. 63, No. 1-4, June 1985, London, (G.B.), Y. Venevtsev et al., pages 217-219. In this paper the results of high temperature X-ray, dielectric and nonlinear optical investigations of $CaGe_2O_5$ crystals with sphenlike structure indicate a phase transition at 720K. The pyro electric effect and polysynthetic twinning are observed below 720K. Also the material is ferro electric with a Curie point (Tc) of 720K.

Calcium mesodigermanate has also been prepared as a ceramic plate for use as a cathode ray tube face plate. This is described in U.K. Patent Application No. 8 431 838.

According to this invention an optical component comprises a substrate of single crystal $CaGe_2O_5$.

The optical component may be in sheet or bulk form with flat or curved surfaces.

The component may be formed of stoichiometric amounts of Ca, Ge, and O or amounts slightly, e.g. 2 – 3 % weight, away from the stoichiometric ratio. It may be undoped or may include dopants, e.g. rare earths such as Ce, Tb, Eu, Nd, Ho, Tm, Dy, or dopants such as Mn.

Samples of very pure single crystal $CaGe_2O_5$ when prepared as plates have been found to have the following properties:

1. Coloured violet – from light to dark, depending on the method of preparation i.e. contains colour centres, doping with Sb removes these colour centres;

2. Changes colour to brown on irradiation by ultra-violet light. The brown colour remains for long periods in the absence of ambient light and changes back in about 7 days under ambient light. Heating to about 200°C restores the original colouration in a short period (<1 min) depending on heating rate;

3. The plate is highly birefringent; the crystal demonstrates a natural birefringence of about 0.75 x that of calcite and a pseudo birefringence of 20.0 x that of calcite;

4. The crystal has an orientated layered structure throughout its bulk with the layers (lamellae) about 2 – 3 μm thick. The layers have different optical properties;

5. The crystal when rotated in ambient light shows colour change with direction from violet to colourless, i.e. it is dichroic;

6. When doped with Mn it scintillates in X-ray radiations and on subsequent heating also emits visible red radiation (thermoluminescence).

The invention will be described, by way of example only, with reference to the accompanying drawings of which:

Figure 1    is a view of a storage plate for recording information, together with a scanning system for writing information on the plate.

Figure 2    is a schematic view of a beam splitter dividing laser light into two directions;

Figure 3    is a view of an acousto-optic switch;

Figure 4    is a schematic view of crystal growing apparatus;

Figure 5    is a disc storage system using a laser to write information;

Figure 6    is a view of a read system for Figure 5; and

Figure 7    is an enlarged view of part of Figure 6.

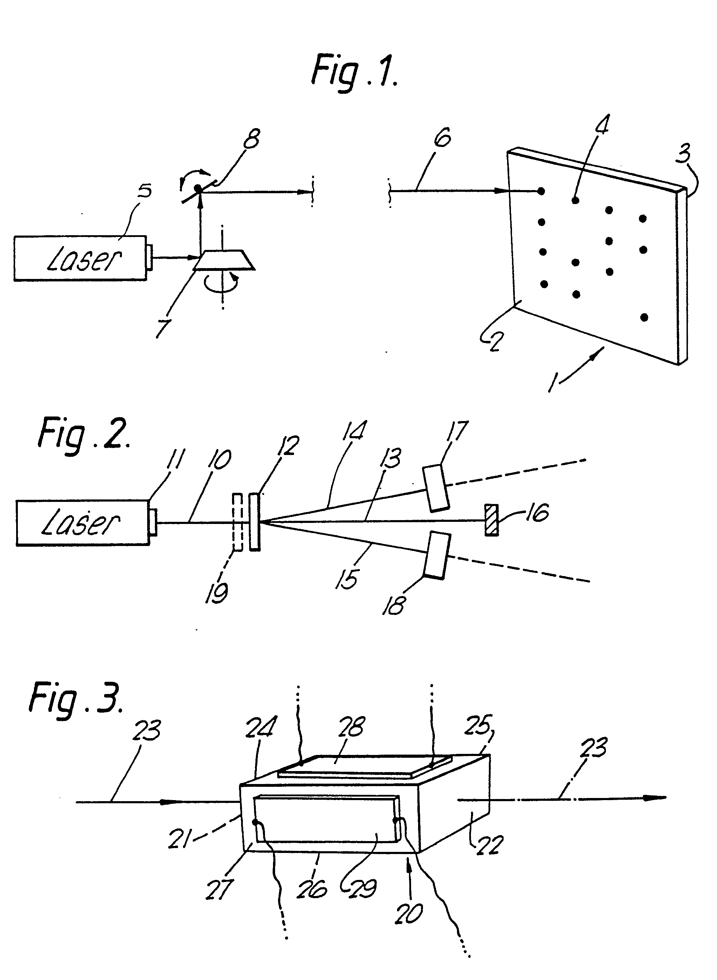

As shown in Figure 1 a storage plate 1 comprises a plate of $CaGe_2O_5$ of the required size, e.g. 5 cm by 5 cm by 0.25 cm. The large front and back, faces 2, 3 are cut in the <101 > plane so that the thin layers (lamellae) forming the crystal are parallel to these large faces 2, 3.

The storage plate 1 may be used to record digital information by the presence or absence of brown coloured areas 4 in a violet background. These brown coloured areas 4 can be written by irradiation with an ultra-violet laser 5, beam 6. Scanning line and vertical mirrors 7, 8 scan the laser beam 6 over surface of the plate 1 whilst the laser 5 is pulsed on and off. The result is a matrix of information represented by small brown coloured dots 4 in the plate 1. Information may be read by a scanning system similar to that in Figure 1 with a detector replacing the laser 5.

As written the information remains for months in the absence of light. To erase the plate 1 is heated e.g. at 200°C until the original colour is restored. This takes about 1 minute or less depending on heating rate.

The plate of Figure 1 may be used as a holographic storage plate. The colour centres in the different layers change colour as the plate is exposed to both a reference beam and direct beam from a subject being recorded.

Figure 2 shows the component of this invention in use as a switchable beam splitter sheet. Light from a helium neon laser 11 is passed through a sheet 12 of $CaGe_2O_5$ normal to the lumellae described where it is split into three beams 13, 14, 15. The central beam 13 appears unpolarised, since it comprises two overlapping orthogonally polarised beams, and is stopped by an absorber 16; the two outer beams 14, 15 are polarised at 90° to one another. Two polarisation shutters 17, 18 in the beam 14, 15 respectively allow these outer beams to be switched OFF selectively. The system of Figure 2 is thus an optical switch. Polarisation shutters 17, 18 may be formed by the known twisted nematic liquid crystal device. These comprise a nematic liquid crystal material formed into a 90° twist and arranged between crossed linear polarisers. When switched by an electric field the device either passes or prevents transmission of linear polarised light.

Having a second sheet 19 orthogonal to the sheet 12 results in the beam 10 being split into nine beams of light each of which may be switched by suitable shutters.

Alternatively, through reciprocity, light from separate sources may be directed along paths 14, 15 for combining in the sheet 12 to a single beam 10.

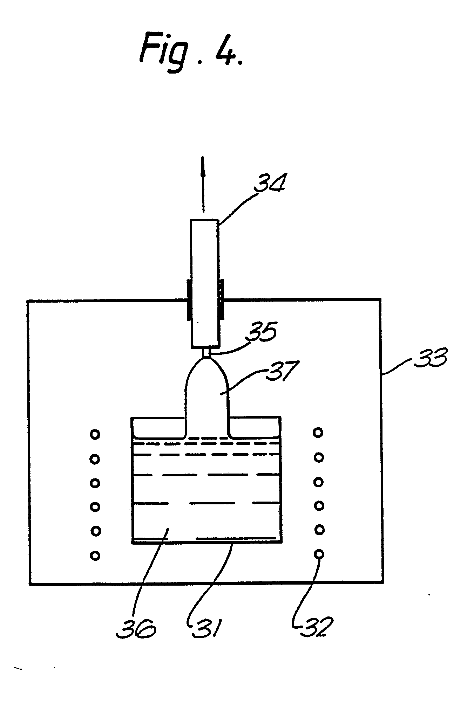

Figure 3 shows an optical switch 20 comprising a block of $CaGe_2O_5$ with polished end faces 21, 22 through which light 23 may pass. The other faces 24, 25, 26, 27 may be finished flat with parallel or non-parallel facing surfaces, and adjacent faces orthogonal or non-orthogonal to one another.

Facing top and bottom 24, 26, and side 25, 27 faces respectively carry transducers 28, 29 (only one shown per pair of faces). These transducers 28, 29 comprise a thin layer of piezo electric material e.g. zinc oxide, between two sheet electrodes. When a modulated voltage is applied to the transducers 28, 29 acoustic waves are transmitted into the bulk $CaGe_2O_5$. This acoustic energy modulates light 23 passing through the block.

In a modification only one of the opposing pair of faces carries a transducer; the other face may be roughened and angled to prevent reflection. Alternatively the two opposing faces may be polished flat and parallel to permit the maintenance of a standing acoustic wave pattern.

In another modification the transducers are replaced by sheet electrodes to any desired pattern. A modulated field is applied between opposing electrodes to modulate light transmission. Alternatively the electrodes may be patterned into interdigital comb transducers for launching and receiving acoustic waves.

The distance between faces 21, 22 may be made thin with the lamellae arranged normal to the light 23. When a monochromatic light is directed through this thinned block the output is a series of diffraction lines.

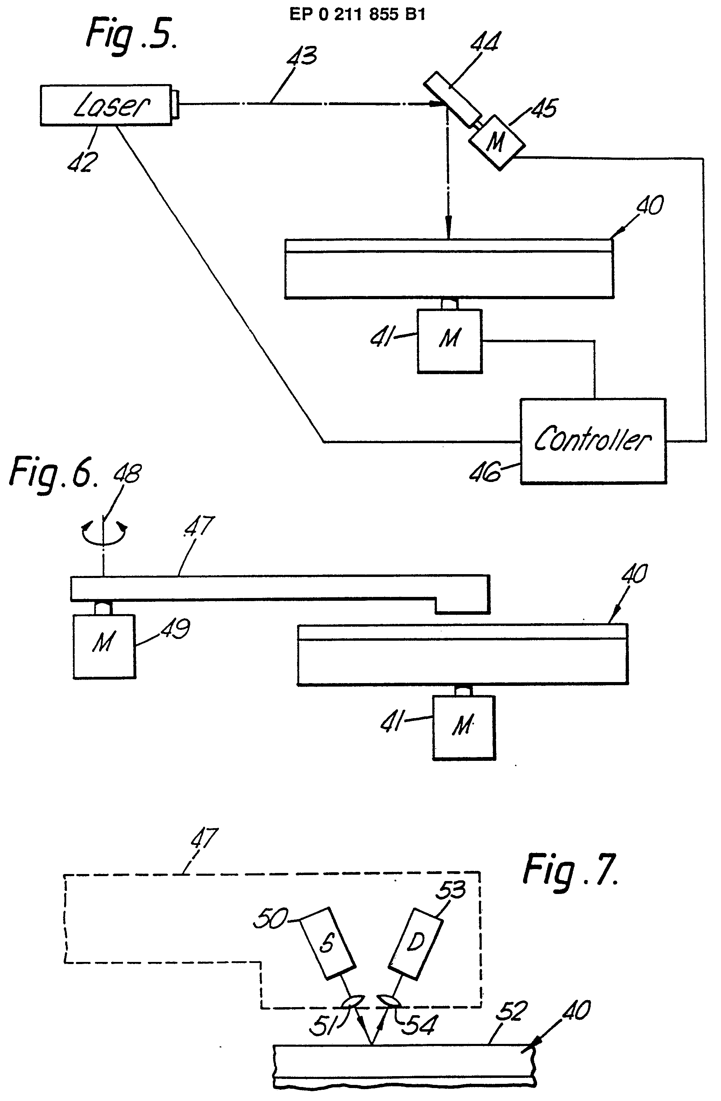

As shown in Figure 5 a disc storage system comprises disc shaped plate 40 of calcium mesodigermanate mounted for rotation by a motor 41. A pulsed laser 42 has its output beam 43 reflected by a mirror 44 onto the disc 40. This mirror 44 is mounted for rotation by a motor 45. Both motors 41, 45 and the pulsing of the laser 42 are controlled by a controller 46, e.g. a computer output, to write discrete small areas of colour in concentric tracks on the disc 40 in a manner similar to that on magnetic disc for computers.

Figures 6, and 7 show how the disc of Figure 5 is read. As before the disc 40 is mounted for rotation by the motor 41. A pick-up arm 47 is mounted to rotate about a vertical axis 48 as controlled by a stepper motor 49. Inside the arm 47, as shown better in Figure 7, is a light source 50 whose output is focussed by a lens 51 to a track 52 on the disc 40. Reflected light from the illuminated track is detected by a photodetector 53 through a lens 54. The presence or absence of coloured spots is used in a manner similar to that in reading a magnetic disc.

Other uses of $CaGe_2O_5$ include:

— Scintillators, the crystal emits light when irradiated by ionising radiation e.g. X-ray. This may be used in body scanners to replace zinc tungstate;
— Diffraction gratings; plates of the crystal are placed with the lamellae parallel to the incident beam direction;
— Waveguide lasers, a laser rod with polished parallel ends is made of the crystal containing suitable ions and optically pumped, as for YAG lasers;
— Optical waveguides. The thin layers act as waveguides. Thin plates of the crystal can thus act as small section fibres.

Single crystalline $CaGe_2O_5$ may be prepared by apparatus shown in Figure 4. A Pt crucible 31 is heated by an electric furnace 32 in an enclosed chamber 33. The atmosphere in this chamber may be air. A lifting rod 34 has attached to its lower end a seed crystal 35, with the < 101 > direction co-linear with the lifting rod. Calcium oxide and germanium dioxide in the molar ratio 1 : 2 are placed in the crucible 31. The furnace 32 heats the crucible 31 and contents until a melt 36 forms with a temperature of 1,285°C at the surface. The seed 35 is dipped into the melt 36 and slowly raised at typically 0.75 mms per hour whilst a crystal 37 grows. At the growing crystal 37 of $CaGe_2O_5$ slowly cools it undergoes a phase transition at 500°C from a monoclinic sphere-like structure to a triclinic structure. This restructuring

leads to the multi-layered dielectric structure described.

Doped crystals are provided by introducing small amounts of dopant, e.g. Mn or rare earth ions e.g. Tb etc., into the melt 36 before crystal growth commences.

After growth the crystal 37 is removed from the lifting rod 34, and then cut and ground to the required crystalographic orientation and shape.

## Claims

1. An optical component comprising a substrate having a light receiving and a light transmissive face, the substrate being of single crystal $CaGe_2O_5$ having an orientated layered structure through its bulk.

2. The component of claim 1 forming a polarising beam splitter arranged with the layers parallel to one of the faces.

3. The component of claim 1 forming an information storage plate and further comprising a laser, means for scanning the laser output over the surface of the plate, and means for pulsing the laser ON and OFF as laser output is scanned over the plate.

4. The component of claim 1 forming an information storage plate and further comprising a light source, means for scanning light output from the source over the plate, and means for detecting light reflected off the plate during scanning.

5. The component of claim 2 forming an optical switch and further comprising polarisation shutters arranged to receive light in a plurality of paths from the component when the component is illuminated with a beam of light.

6. The component of claim 1 including a dopant.

7. The component of claim 6 wherein the dopant is one selected from Ce, Tb, Eu, Nd, Ho, Tm, Dy, Mn, or Sb.

## Patentansprüche

1. Optisches Teil, das ein Substrat mit einer lichtaufnehmenden und einer lichtdurchlässigen Fläche aufweist, wobei das Substrat ein $CaGe_2O_5$-Einkristall mit einer orientierten Schichtstruktur, die sich über sein gesamtes Volumen erstreckt, ist.

2. Teil gemäß Anspruch 1, das einen polarisierten Strahlteiler bildet, der mit den Schichten parallel zu einer der Flächen angeordnet ist.

3. Teil gemäß Anspruch 1, das eine Informationsspeicherplatte bildet und ferner einen Laser, eine Einrichtung zum Abtasten der Laserausgabe auf der Plattenoberfläche und eine Einrichtung zum EIN- und AUS-Pulsen des Lasers, wenn die Laserausgabe auf der Platte abgetastet wird, aufweist.

4. Teil gemäß Anspruch 1, das eine Informationsspeicherplatte bildet und ferner eine Lichtquelle, eine Einrichtung zum Abtasten der aus der Quelle hervorgehenden Lichtausgabe auf der Platte und eine Einrichtung zum Ermitteln des von der Platte während des Abtastens reflektierten Lichtes, aufweist.

5. Teil gemäß Anspruch 2, das einen optischen Schalter bildet und ferner Polarisationsblenden aufweist, die so angeordnet sind, daß sie das Licht in einer Mehrzahl von Wegen vom Teil empfangen, wenn das Teil mit einem Lichtstrahl beleuchtet wird.

6. Teil gemäß Anspruch 1, das eine Dotierungssubstanz aufweist.

7. Teil gemäß Anspruch 6, in dem die Dotierungssubstanz ein Element ist, das aus den Elementen Ce, Tb, Eu, Nd, Ho, Tm, Dy, Mn oder Sb ausgewählt wird.

## Revendications

1. Composant optique comprenant un substrat ayant une face de réception de la lumière et une face de transmission de la lumière, le substrat étant en un monocristal $CaGe_2O_5$ ayant dans toute sa masse une structure à couches orientées.

2. Composant selon la revendication 1, formant dispositif de fractionnement de faisceau polarisant, agencé avec les couches parallèles à l'une des faces.

3. Composant selon la revendication 1, formant plaque de mémorisation d'informations et comprenant en outre un laser, un dispositif destiné à balayer le signal de sortie du laser sur la surface de la plaque, et un dispositif de commande pulsée du laser par tout ou rien lorsque le signal de sortie du laser balaye la plaque.

4. Composant selon la revendication 1, formant plaque de mémorisation d'informations et comprenant en outre une source lumineuse, un dispositif de balayage du signal lumineux de la source sur la plaque, et un dispositif de détection de la lumière réfléchie par la plaque pendant le balayage.

5. Composant selon la revendication 2, formant commutateur optique et comprenant en outre: des obturateurs polarisants destinés à recevoir la lumière suivant plusieurs trajets provenant du composant lorsque le composant est éclairé par un faisceau lumineux.

EP 0 211 855 B1

6. Composant selon la revendication 1, contenant une matière de dopage.

7. Composant selon la revendication 6, dans lequel la matière de dopage est choisie parmi Ce, Tb, Eu, Nd, Ho, Tm, Dy, Mn ou Sb.

Fig .1.

Fig .2.

Fig .3.

# Fig . 4.

Fig .5.

EP 0 211 855 B1

Fig.6.

Fig .7.